# EUROPEAN PATENT SPECIFICATION

(11) **EP 3 796 767 B1**
(45) Date of publication and mention of the grant of the patent: **06.03.2024**
(21) Application number: 19866652.1
(22) Date of filing: 30.09.2019
(51) Int. Cl.: H05K 7/20, B32B 5/18, B32B 15/08, B22F 3/11, B22F 7/00, C22C 1/08

(54) **COMPOSITE MATERIAL**
VERBUNDWERKSTOFF
MATÉRIAU COMPOSITE

(30) Priority: 28.09.2018 KR 20180115967
(43) Date of publication of application: 24.03.2021
(73) Proprietor: LG CHEM, LTD., Yeongdeungpo-gu, Seoul 07336 (KR)
(72) Inventor: LEE, Yeon Soo, Daejeon 34122 (KR); YOO, Dong Woo, Daejeon 34122 (KR); LEE, Jin Kyu, Daejeon 34122 (KR)
(74) Representative: Goddar, Heinz J.
(86) International application number: PCT/KR2019/012748
(87) International publication number: WO 2020/067839

(56) References cited:
- WO-A1-2017/161993
- WO-A2-2016/016660
- CN-A- 106 400 062
- JP-A- 2014 534 645
- KR-A- 20150 031 213
- KR-A- 20160 039 539
- US-A1- 2014 302 305
- US-A1- 2016 276 651
- US-A1- 2018 162 098
- US-A1- 2018 212 250
- ZOU NING ET AL: "Compressive mechanical property of porous magnesium composites reinforced by carbon nanotubes", JOURNAL OF MATERIAL SCIENCE, KLUWER ACADEMIC PUBLISHERS, DORDRECHT, vol. 51, no. 11, 16 February 2016 (2016-02-16), pages 5232-5239, XP035835761, ISSN: 0022-2461, DOI: 10.1007/S10853-016-9824-8 [retrieved on 2016-02-16]
- LORENTE-AYZA MARIA-MAGDALENA ET AL: "Comparison of porosity assessment techniques for low-cost ceramic membranes", BOLETIN DE LA SOCIEDAD ESPANOLA DE CERAMICA Y VIDRIO., vol. 56, no. 1, 1 January 2017 (2017-01-01), pages 29-38, XP093051205, ES ISSN: 0366-3175, DOI: 10.1016/j.bsecv.2016.09.002

## Description

### Technical Field

The present application relates to a composite material and a method for producing the same.

### Background Art

Heat-dissipating materials can be used in various applications. For example, since batteries and various electronic apparatuses generate heat during operation, a material capable of effectively controlling such heat is required.

As materials having good heat dissipation properties, ceramic materials having good thermal conductivity and the like are known, but since such materials have poor processability, a composite material produced by blending the ceramic filler or the like exhibiting high thermal conductivity in a polymer matrix can be used.

However, since a large amount of filler components must be applied in order to secure high thermal conductivity by the above method, various problems arise. For example, in the case of a material containing a large amount of filler components, the material itself tends to become hard, and in such a case, impact resistance or the like is deteriorated.

Accordingly, by providing a composite material using the metal foam itself as a heat pathway, the present application is intended to implement effective heat dissipation characteristics as compared to the existing heat-dissipating material. However, there is a limit to the thermal conductivity that can be obtained only by the metal foam without any additional thermally conductive filler, and therefore, in order to apply to more various fields, studies that simultaneously satisfy superior thermal conductivity, impact resistance, and pore characteristics are required.

US2018/162 098 A1 discloses a fused sheet for electromagnetic wave absorption/extinction and shielding, and for electronic equipment high heat dissipation. The fused sheet for electromagnetic wave absorption/extinction and shielding, and for electronic equipment high heat dissipation includes a premolded graphite sheet prepared by molding a graphite substrate into a sheet form having a density in a range of 0.1-1.5 g/cm³ and an incomplete state of crystal structure; and a porous metal sheet having a plurality of pores connected to upper and lower surfaces of the porous metal sheet, wherein the premolded graphite sheet is stacked on one surface of the porous metal sheet, and press molded to be integrally attached and combined, so as to have a density of 1.6 g/cm³ to 6.0 g/cm³.

WO 2016/016 660 A2 provides processes for preparing a porous composite material comprising a metal and a two-dimensional nanomaterial. In one aspect, the processes comprise the steps of: providing a powder comprising metal particles; heating the powder such that the metal particles fuse to form a porous scaffold; and forming a two-dimensional nanomaterial on a surface of the porous scaffold by chemical vapour deposition (CVD).

Zou Ning et al., "Compressive mechanical property of porous magnesium composites reinforced by carbon nanotubes", Journal of Material Science, Kluwer Academic, vol. 51, no. 11, 2016, pp 5232-5239; relates to porous magnesium/carbon nanotube (Mg/CNT) composites with various CNT concentrations and porosities in the range from 20% to 40%.

WO 2017/161 993 A1 relates to a foam skeleton reinforced composite, comprising a foam skeleton and a matrix. The foam skeleton is selected from at least one of a metal foam skeleton, an inorganic non-metal foam skeleton, and an organic foam skeleton. The matrix is selected from a metal or polymer.

CN 106 400 062 A provides a copper and carbon composite material and a manufacturing method and device thereof, and relates to the technical field of material manufacturing.

US 2014/302305 A1 discloses a further composite.

### Disclosure

### Technical Problem

It is an object of the present application to provide a composite material having excellent impact resistance or processability, and pore characteristics, while having excellent heat dissipation performance, and a method for producing the composite material.

### Technical Solution

The present application relates to a composite material comprising a metal foam and a graphene component present on the surface of the metal foam or inside the metal foam, wherein the metal foam has a thickness range of 70 µm to 270 µm; and wherein the metal foam has pores and a porosity in a range of 80% to 98% as calculated from the density of the metal foam. In the present application, the term composite material means a material comprising a metal foam and a graphene component, which is described below.

In the present application, the term metal foam or metal skeleton means a porous structure comprising two or more metals as a main component. Here, the fact that the metals are used as the main component means a case where the ratio of the metals is 55 wt% or more, 60 wt% or more, 65 wt% or more, 70 wt% or more, 75 wt% or more, 80 wt% or more, 85 wt% or more, 90 wt% or more, or 95 wt% or more based on the total weight of the metal foam or the metal skeleton. The upper limit of the ratio of the metals contained as the main component is not particularly limited, which may be, for example, 100 wt%.

The term porousness may mean a case where it has a porosity of 80% or more. The upper limit of the porosity is 98% or less. Here, the porosity can be calculated in a known manner by calculating the density of the metal foam or the like.

The composite material comprises a metal foam and a graphene component present on the surface of the metal foam or inside the metal foam. An exemplary metal foam comprises pores, and the size of the pores may be 20 µm to 380 µm, 25 µm to 350 µm, 30 µm to 330 µm, 35 µm to 300 µm, 40 µm to 280 µm, 42 µm to 230 µm or 45 µm to 180 µm. Also, in an embodiment of the present application, the graphene component may be included in a range of 10⁻⁵ to 10⁻¹wt% in the composite material. The weight ratio of the graphene component may be, for example, in the range of more than 10⁻⁵, less than 10⁻¹wt%, 5 x 10⁻⁵ to 5 x 10⁻²wt%, 10⁻⁴ to 10⁻²wt%, 5 × 10⁻⁴ to 5 × 10⁻³wt%, 8 × 10⁻⁴ to 3 × 10⁻³wt%. The weight ratio is a ratio when the total weight of the metal foam and the graphene component has been calculated as 100. Therefore, when another component to be described below, for example, a polymer layer is formed, the weight ratio between the metal foam and the graphene component may be in the above range. In the present application, the fact that the graphene component is present inside the metal foam may mean that the graphene component forms a layer in the internal pores of the metal foam and is present therein. The composite material of the present application provides a metal foam having excellent impact resistance and pore characteristics together with high thermal conductivity characteristics, whereby it may be used as a material for controlling heat, such as a heat-dissipating material. In this specification, the average size of the pores may be, for example, an average size according to a D50 particle size analysis.

In an embodiment of the present application, the graphene component may form a graphene layer on at least one surface of the metal foam or may be filled and present in voids inside the metal foam, and may also be filled inside the metal foam optionally, while forming the graphene layer. In the case of forming the graphene layer, the graphene component may form the graphene layer on at least one surface, a part of the surface, or all surfaces of the metal foam. In one example, the graphene component may form the graphene layer on at least the upper surface and/or the lower surface, which are major surfaces of the metal foam. The graphene layer may also be formed to cover the entire surface of the metal foam, or may also be formed to cover only a part of the surface.

In an embodiment of the present application, the graphene layer may be formed in a single layer or multi-layer structure, and the graphene layer may have a thickness range in a range of 10 nm or less, 8 nm or less, or 5 nm or less. The lower limit is not particularly limited, but may be 0.001 nm or 0.01 nm. As the graphene component is introduced to the surface of the metal foam having the above-described specific pore size and the surface of the pores inside the metal foam in a specific content or a specific thickness, the present application can implement a graphene-deposited structure more effectively than the conventional graphene-deposited metal foam, where this structure can be implemented by the pore size, pore distribution, graphene content and/or graphene thickness. Accordingly, the metal foam of the present application provides a composite material having oxidation resistance, impact resistance or processability and excellent porosity while having excellent heat dissipation performance. The graphene component may be grown by chemical vapor deposition (CVD) on the surface of the metal foam, without being limited thereto.

In one example, the composite material may have a thermal conductivity of 1.65 W/mK or more, 1.7 W/mK or more, or 2.0 W/mK or more. The higher the thermal conductivity of the composite material, the composite material may have more excellent thermal control functions, which is not particularly limited, and in one example, it may be about 100 W/mk or less, 90 W/mK or less, 80 W/mK or less, 70 W/mK or less, 60 W/mK or less, 50 W/mK or less, 40 W/mK or less, 30 W/mK or less, 20 W/mK or less, or 10 W/mk or less.

The thermal conductivity of the composite material can be measured in a manner known in the art. For example, by obtaining thermal diffusivity (A), specific heat (B), and density (C) of the composite material, the thermal conductivity can be obtained by an equation of thermal conductivity = ABC. The thermal diffusivity (A) can be measured using a laser flash method (LFA equipment, model name: LFA467), the specific heat can be measured using DSC (differential scanning calorimeter) equipment, and the density can be measured using the Archimedes method. In addition, the thermal conductivity may be a value for the thickness direction (Z axis) of the composite material.

Among physical properties mentioned in this specification, when the measured temperature affects the relevant physical property, the physical property is measured at room temperature, unless otherwise specified. The term room temperature is a natural temperature without warming or cooling, which may mean, for example, a temperature in a range of about 10 °C to about 30 °C, or a temperature of about 23 °C or about 25 °C or so.

The composite material of the present application can also stably secure other physical properties such as processability or impact resistance while having such an excellent thermal conductive property and these effects can be achieved by the contents described herein.

The form of the metal foam included in the composite material is not particularly limited, but in one example, it may be in a film shape. The composite material of the present application may further comprise a polymer component present on the surface of the metal foam in the form of a film or the graphene component. In one example, the graphene component may form a graphene layer on the surface of the metal foam, and the polymer component may be formed on the graphene layer or on the surface on which the graphene component is not formed among the surfaces of the metal foam.

Such a polymer component may form a surface layer on at least one surface of the metal foam or may be filled and present in voids inside the metal foam, and may also be filled inside the metal foam optionally, while forming the surface layer. In the case of forming the surface layer, the polymer component may form the surface layer on at least one surface, a part of the surface, or all surfaces of the metal foam. In one example, the polymer component may form the surface layer on at least the upper surface and/or the lower surface, which are major surfaces of the metal foam. The surface layer may also be formed to cover the entire surface of the metal foam, or may also be formed to cover only a part of the surface.

The metal foam in the composite material may have a porosity in the range of about 80% to 98%. The metal foam having such a porosity has a porous metal skeleton forming a suitable heat transfer network, whereby it can ensure an excellent thermal conductivity even if a small amount of the relevant metal foam is applied. In another example, the porosity may be 95% or less, 90% or less, 88% or less, 85% or less, 83% or less.

As described above, the metal foam may be in the form of a film. In this case, the thickness of the film can be adjusted in consideration of the desired thermal conductivity or thickness ratio, and the like, in manufacturing a composite material according to a method to be described below. In order to ensure the target thermal conductivity, the thickness of the film is, 70µm or more. The upper limit of the thickness of the film is controlled according to the purpose, which is not particularly limited, but 270 µm or less.

In this specification, when the thickness of the relevant target is not constant, the thickness may be a minimum thickness, a maximum thickness or an average thickness of the target.

The metal foam may be a material having high thermal conductivity. In one example, the metal foam may comprise or consist of a metal or a metal alloy having thermal conductivity of about 8 W/mK or more, about 10 W/mK or more, about 15 W/mK or more, about 20 W/mK or more, about 25 W/mK or more, about 25 W/mK or more, about 30 W/mK or more, about 35 W/mK or more, about 40 W/mK or more, about 45 W/mK or more, about 50 W/mK or more, about 60 W/mK or more, about 70 W/mK or more, about 75 W/mK or more, about 80 W/mK or more, about 85 W/mK or more, or about 90 W/mK or more. The thermal conductivity is not particularly limited, which may be, for example, about 1,000 W/mk or less or so, because the higher the numerical value, the desired thermal control characteristics can be ensured while applying a small amount of the metal foam.

The skeleton of the metal foam may be composed of various kinds of metals or metal alloys, where a material capable of exhibiting thermal conductivity in the above-mentioned range may be selected from these metals or metal alloys. Such a material can be exemplified by any metal selected from the group consisting of copper, gold, silver, aluminum, nickel, iron, cobalt, magnesium, molybdenum, tungsten and zinc, or an alloy of two or more thereof, and the like, but is not limited thereto.

Such metal foams are variously known, and methods for producing metal foams are also variously known. In the present application, such a known metal foam or the metal foam produced by the known method may be applied.

As a method for producing a metal foam, a method of sintering a pore-forming agent such as a salt and a composite material of a metal, a method of coating a metal on a support such as a polymer foam and sintering in that state, a slurry method, and the like is known. Furthermore, the metal foam can also be produced by a method disclosed in Korean Patent Application No. 2017-0086014, 2017-0040971, 2017-0040972, 2016-0162154, 2016-0162153 or 2016-0162152, and the like, which is a prior application of the present applicant.

The metal foam may also be produced by the induction heating method, among the methods disclosed in the prior applications, where the metal foam may comprise at least a conductive magnetic metal. In this case, the metal foam may comprise the conductive magnetic metal in an amount of 30 wt% or more, 35 wt% or more, 40 wt% or more, 45 wt% or more, or 50 wt% or more on the basis of weight. In another example, the ratio of the conductive magnetic metal in the metal foam may be about 55 wt% or more, 60 wt% or more, 65 wt% or more, 70 wt% or more, 75 wt% or more, 80 wt% or more, 85 wt% or more, or 90 wt% or more. The upper limit of the ratio of the conductive magnetic metal is not particularly limited, which may be, for example, less than about 100 wt% or 95 wt% or less.

If necessary, the metal component may comprise a second metal different from the above-described conductive magnetic metal together with the metal. In this case, the metal foam may be formed of a metal alloy. As the second metal, a metal having relative magnetic permeability and/or conductivity in the same range as that of the above-mentioned conductive magnetic metal may also be used, and a metal having relative magnetic permeability and/or conductivity outside such a range may be used. In addition, as the second metal, one metal may also be included and two or more metals may also be included. The kind of such a second metal is not particularly limited as long as it is different from the conductive magnetic metal to be applied, and for example, one or more metals, which are different from the conductive magnetic metal, in copper, phosphorus, molybdenum, zinc, manganese, chromium, indium, tin, silver, platinum, gold, aluminum or magnesium, and the like, may be applied, without being limited thereto.

The kind of the polymer component included in the composite material of the present application is not particularly limited, which may be selected in consideration of, for example, processability, impact resistance, insulation properties or the like of the composite material. An example of the polymer component applicable in the present application may include one or more selected from the group consisting of a known acrylic resin, silicone resin, epoxy resin, urethane resin, amino resin and phenol resin, but is not limited thereto.

In the case of the composite material, it is possible to secure excellent thermal conductivity while minimizing the ratio of components securing the thermal conductivity mainly through the application of the above-described metal foam, thereby securing the desired physical properties without damaging processability or impact resistance, and the like.

The present application also relates to a method for producing a composite material in the above type. The production method comprises forming a graphene component on the surface of or inside the metal foam in the form of a film.

Generally, the graphene component can be grown by applying a carbon source and heat to a support comprising a metal catalyst, as a chemical vapor deposition method. In the present application, the metal foam may be used as the support. As the carbon source, one selected from the group consisting of carbon monoxide, carbon dioxide, methane, ethane, ethylene, ethanol, acetylene, propane, butane, butadiene, pentane, pentene, cyclopentadiene, hexane, cyclohexane, benzene, toluene and a combination thereof can be used. For example, when the carbon source is heat-treated at a temperature of 300°C to 2000°C while being supplied in a gaseous phase and then cooled, the carbon components present in the carbon source may be bonded to grow on the surface of the metal foam.

The kind of such a chemical vapor deposition (CVD) method includes high temperature chemical vapor deposition (RTCVD), inductively coupled plasma chemical vapor deposition (ICP-CVD), low pressure chemical vapor deposition (LPCVD), atmospheric pressure chemical vapor deposition (APCVD), metal organic chemical vapor deposition (MOCVD) or chemical vapor deposition (PECVD), and the like.

The production method of the present application may comprise a step of producing a metal foam before the step of forming a graphene component.

The method for producing a metal foam may comprise a step of sintering a green structure including a metal component having a metal. In the present application, the term green structure means a structure before undergoing a process performed to form a metal foam, such as the sintering, that is, a structure before a metal foam is produced. In addition, even if the green structure is referred to as a porous green structure, it is not necessarily porous by itself, and it can be referred to as a porous green structure for convenience, as long as it can finally form a metal foam, which is a porous metal structure.

In the present application, the green structure may be formed using a slurry including at least a metal component, and first and second solvents.

The metal component forming the green structure may be in the form of powder. For example, the metals in the metal component may have an average particle diameter in a range of about 0.1 µm to about 200 µm. In another example, the average particle diameter may be about 0.5 µm or more, about 1 µm or more, about 2 µm or more, about 3 µm or more, about 4 µm or more, about 5 µm or more, about 6 µm or more, about 7 µm or more, or about 8 µm or more. In another example, the average particle diameter may be about 150 µm or less, 100 µm or less, 90 µm or less, 80 µm or less, 70 µm or less, 60 µm or less, 50 µm or less, 40 µm or less, 30 µm or less, or 20 µm or less. As the metal in the metal component, those having different average particle diameters may be applied. The average particle diameter can be appropriately selected in consideration of the shape of the desired metal foam, for example, the thickness or the porosity of the metal foam, which is not particularly limited.

The green structure may be formed using a slurry comprising first and second solvents together with the metal component including the metal.

Here, as the first and second solvents, those having different dielectric constants may be applied. In one example, one having a dielectric constant of 20 or more may be used as the first solvent, and one having a dielectric constant of 15 or less may be used as the second solvent. In this specification, the dielectric constant may be a dielectric constant measured at any temperature in a range of about 20 °C to 25 °C. When two solvents having different dielectric constants are mixed and used, an emulsion can be formed and a pore structure can be formed by such an emulsion.

In order to increase formation efficiency of the pore structure, the first and second solvents may be selected such that a ratio (D1/D2) of the dielectric constant (D1) of the first solvent to the dielectric constant (D2) of the second solvent is in a range of 5 to 100. In another example, the ratio (D1/D2) may be about 90 or less, about 80 or less, about 70 or less, about 60 or less, or about 50 or less.

The range of specific dielectric constants of the first solvent and the second solvent is not particularly limited as long as it satisfies the above.

In one example, the dielectric constant of the first solvent may be in the range of 20 to 100. In another example, the dielectric constant of the first solvent may be about 25 or more or about 30 or more. Also, in another example, the dielectric constant of the first solvent may be about 95 or less, about 90 or less, or about 85 or less.

Such a first solvent can be exemplified by, for example, water, an alcohol such as a monohydric alcohol having 1 to 20 carbon atoms, acetone, N-methyl pyrrolidone, N,N-dimethylformamide, acetonitrile, dimethyl acetamide, dimethyl sulfoxide or propylene carbonate, and the like, but is not limited thereto.

The dielectric constant of the second solvent may be, for example, in the range of 1 to 15. In another example, the dielectric constant of the second solvent may be about 13 or less, about 11 or less, about 9 or less, about 7 or less, or about 5 or less.

Such a second solvent can be exemplified by an alkane having 1 to 20 carbon atoms, an alkyl ether having an alkyl group with 1 to 20 carbon atoms, pyridine, ethylene dichloride, dichlorobenzene, trifluoroacetic acid, tetrahydrofuran, chlorobenzene, chloroform or toluene, and the like, but is not limited thereto.

The ratio of each component in such a slurry can be adjusted suitably, which is not particularly limited.

For example, the ratio of the metal component in the slurry may be in a range of 100 to 300 parts by weight relative to 100 parts by weight of the total weight of the first and second solvents. In another example, the ratio may be about 290 parts by weight or less, about 250 parts by weight or less, about 200 parts by weight or less, about 150 parts by weight or less, or about 120 parts by weight or less, and in another example, it may be about 110 parts by weight or more, or 120 parts by weight or more.

In addition, the ratio of the first and second solvents in the slurry may be adjusted so that relative to 100 parts by weight of any one of the first and second solvents, the weight part of the other solvent is in a range of about 0.5 to 10 parts by weight. In another example, the ratio may be about 9 parts by weight or less, about 8 parts by weight or less, about 7 parts by weight or less, about 6 parts by weight or less, about 5 parts by weight or less, about 4 parts by weight or less, or about 3 parts by weight, and in one example, it may be about 1 part by weight or more, about 1.5 parts by weight or more, or about 2 parts by weight or more. For example, the weight ratio of the second solvent to 100 parts by weight of the first solvent in the slurry may be in the above range, or the weight ratio of the first solvent to 100 parts by weight of the second solvent may be in the above range.

The slurry may further comprise a binder, if necessary. The kind of such a binder is not particularly limited, which may be appropriately selected depending on the kind of the metal component or solvent, and the like applied upon producing the slurry. For example, the binder can be exemplified by an alkylcellulose having an alkyl group with 1 to 8 carbon atoms such as methylcellulose or ethylcellulose, a polyalkylene carbonate having an alkylene unit with 1 to 8 carbon atoms such as polypropylene carbonate or polyethylene carbonate, or a polyvinyl alcohol-based binder such as polyvinyl alcohol or polyvinyl acetate, and the like, but is not limited thereto.

For example, the binder in the slurry may be included in a ratio of about 10 to 500 parts by weight relative to 100 parts by weight of the aforementioned metal component. In another example, the ratio may be about 450 parts by weight or less, about 400 parts by weight or less, about 350 parts by weight or less, about 300 parts by weight or less, about 250 parts by weight or less, about 200 parts by weight or less, about 150 parts by weight or less, about 100 parts by weight or less, or about 50 parts by weight or less.

The slurry may also comprise known additives, which are additionally required, in addition to the above-mentioned components.

The method of forming the green structure using the slurry as above is not particularly limited. In the field of manufacturing metal foams, various methods for forming green structures are known, and in the present application, all these methods can be applied. For example, the green structure can be formed by maintaining the slurry in a suitable template, or by coating the slurry in an appropriate manner.

The metal foams have generally brittle characteristics due to their porous structural features, thereby being difficultly manufactured in the form of films or sheets, particularly thin films or sheets and having a problem of being easily broken even when they are manufactured. However, according to the method of the present application, it is possible to form a metal foam, in which pores are uniformly formed therein, while having a thin thickness, and having excellent mechanical characteristics.

The green structure formed by such a method may be sintered to produce a metal foam. In this case, the method of performing the sintering for producing the metal foam is not particularly limited, and a known sintering method can be applied. That is, the sintering can be performed in such a manner that an appropriate amount of heat is applied to the green structure in an appropriate manner.

The production method of the present application may further comprise a step of curing a curable polymer composition in a state where the polymer composition is present on the surface of or inside the metal foam.

The details of the metal foams applied in the above method are as described above, and specific matters of the composite material to be manufactured can also follow the above-described contents.

On the other hand, the polymer composition applied in the above is not particularly limited as long as it can form the above-mentioned polymer component through curing or the like, and such polymer components are variously known in the art.

That is, for example, the composite material can be prepared by performing the curing through a known method using a material having appropriate viscosity among known components.

### Advantageous Effects

The present application can provide a composite material having excellent impact resistance or processability and pore characteristics while having excellent heat dissipation performance, and a method for producing the composite material.

### Best Mode

Hereinafter, the present application will be described in detail with reference to examples and comparative examples, but the scope of the present application is not limited to the following examples.

### Example 1

Methyl cellulose and hydropropyl methylcellulose as polymer binders were mixed and stirred in amounts of 0.17 g and 0.30 g, respectively, to dissolve them in 3.54 g of water (dielectric constant at 20 °C: about 80) as a first solvent. After the dissolution was completed, 4.0 g of copper powder, 0.2 g of a surfactant and 0.15 g of ethylene glycol were sequentially introduced thereto and stirred. Thereafter, 0.0.4 g of pentane (dielectric constant at about 20°C: about 1.84) to be used as a blowing agent was introduced and stirred.

The sample prepared through the above process was bar-coated on a silicon nitride plate to a thickness of 200 µm, and heated to 40 °C in a space under humidity of 80% or more and foamed for 1 minute. Then, it was heated under humidity of 60% or less at 90 °C for 30 minutes and the solvent was dried to form a green structure (film). Thereafter, the green structure (film) was baked in a reducing atmosphere at 1000 °C to produce a metal foam.

After the baking process, CH₄ gas was injected into, as the produced metal foam, the foamed copper foam having a pore size of about 50 to 100 µm, a thickness of 200 µm and a porosity of 80% to deposit graphene at 1000 °C.

### Example 2

The graphene-deposited copper foam produced in Example 1 was immersed in a thermosetting resin (Dow Corning, PDMS, Sylgard 527kit) solution, and then extruded to a thickness of 250 µm using a film applicator to remove an excessive amount of the resin. Thereafter, it was cured in an oven at 120 °C for 10 minutes to produce a composite material.

### Comparative Example 1

A metal foam was produced in the same manner as in Example 1, except for depositing no graphene.

### Comparative Example 2

The metal foam without deposited graphene produced in Comparative Example 1 was immersed in a thermosetting resin (Dow Corning, PDMS, Sylgard 527kit) solution, and then extruded to a thickness of 250 µm using a film applicator to remove an excessive amount of the resin. Thereafter, it was cured in an oven at 120 °C for 10 minutes to produce a composite material.

### Comparative Example 3

A composite material was produced by injecting CH₄ gas into a commercially available metal porous body from Alantum (porosity: 90%, thickness: 500 µm, pore size: 400 to 500 µm) to deposit grapheme at 1000 °C.

### Experimental Example 1 - Measurement of thermal Conductivity and thermal resistance

For the composite materials produced in Examples and Comparative Examples, the thermal conductivity and the thermal resistance were measured using TIM Tester 1300 equipment. In the TIM Tester, a cooling plate is located at the bottom and a heat source is located at the top, where the composite materials produced in Examples and Comparative Examples are each cut into a circle having a diameter of 3.3 cm to prepare a sample, which is positioned so that the center of the measuring part is aligned between the cooling plate and the heat source. The lever is turned so that the cooling plate and the heat source are in close contact with the sample between them. At this time, the sample periphery is wrapped with an insulating material so that heat does not escape laterally and heat is transmitted only to the z-axis through the sample. The thermal resistance could be obtained by measuring a heat flux required to keep a temperature difference between two surfaces constant at a constant pressure, and the thermal conductivity was calculated based on this.

**[Table 1]**

| | Thermal conductivity (W/mK) | Thermal resistance (10psi) (K/W) | Thermal resistance (60psi) (K/W) |
|---|---|---|---|
| Example 1 | 1.75 | 0.60 | 0.31 |
| Example 2 | 2.03 | 0.42 | 0.19 |
| Comparative Example 1 | 1.45 | 0.83 | 0.55 |
| Comparative Example 2 | 1.62 | 0.65 | 0.40 |
| Comparative Example 3 | 0.40 | 2.33 | 1.14 |

## Claims

1. A composite material comprising a metal foam and a graphene component present on the surface of the metal foam or inside the metal foam,
wherein the metal foam has a thickness range of 70 µm to 270 µm; and
wherein the metal foam has pores and a porosity in a range of 80% to 98% as calculated from the density of the metal foam.

2. The composite material according to claim 1, wherein the graphene component is included in a range of 10⁻⁵ to 10⁻¹wt% in the composite material.

3. The composite material according to claim 1, wherein the metal foam comprises a metal or a metal alloy having a thermal conductivity of 8 W/mK or more.

4. The composite material according to claim 1, wherein the metal foam has a skeleton comprising one or more metals or metal alloys selected from the group consisting of iron, cobalt, nickel, copper, molybdenum, zinc, manganese, chromium, indium, tin, silver, platinum, gold, aluminum, stainless steel and magnesium.

5. The composite material according to claim 1, further comprising a polymer component present on the surface of the metal foam or graphene.

6. The composite material according to claim 5, wherein the polymer component forms a surface layer on the surface of the metal foam or graphene.

7. The composite material according to claim 5, wherein the polymer component comprises one or more selected from the group consisting of an acrylic resin, a silicone resin, an epoxy resin, a urethane resin, an amino resin and a phenol resin.

8. The composite material according to claim 1, wherein the graphene component forms a graphene layer on the surface of the metal foam or inside the metal foam.

9. The composite material according to claim 8, wherein the graphene layer is a single layer or multi-layer structure.

10. The composite material according to claim 8, wherein the graphene layer has a thickness range of 10 nm or less.

11. The composite material according to claim 1, wherein the composite material has a thermal conductivity of 1.65 W/mK or more.

12. A method for producing the composite material according to claim 1, comprising forming the graphene component on the surface of or inside the metal foam.

## Patentansprüche

1. Verbundmaterial, umfassend einen Metallschaum und eine Graphenkomponente, die auf der Oberfläche des Metallschaums oder innerhalb des Metallschaums vorhanden ist,
wobei der Metallschaum eine Dicke im Bereich von 70 µm bis 270 µm aufweist; und
wobei der Metallschaum Poren und eine Porosität in einem Bereich von 80 % bis 98 % aufweist, wie aus der Dichte des Metallschaums berechnet.

2. Verbundmaterial nach Anspruch 1, bei dem die Graphenkomponente in einem Bereich von 10⁻⁵ bis 10⁻¹ Gew.-% in dem Verbundmaterial enthalten ist.

3. Verbundmaterial nach Anspruch 1, bei dem der Metallschaum ein Metall oder eine Metalllegierung mit einer Wärmeleitfähigkeit von 8 W/mK oder mehr umfasst.

4. Verbundmaterial nach Anspruch 1, bei dem der Metallschaum ein Gerüst aufweist, das ein oder mehrere Metalle oder Metalllegierungen umfasst, die aus der Gruppe ausgewählt sind, die aus Eisen, Kobalt, Nickel, Kupfer, Molybdän, Zink, Mangan, Chrom, Indium, Zinn, Silber, Platin, Gold, Aluminium, Edelstahl und Magnesium besteht.

5. Verbundmaterial nach Anspruch 1, ferner umfassend eine Polymerkomponente, die auf der Oberfläche des Metallschaums oder Graphens vorhanden ist.

6. Verbundmaterial nach Anspruch 5, bei dem die Polymerkomponente eine Oberflächenschicht auf der Oberfläche des Metallschaums oder Graphens bildet.

7. Verbundmaterial nach Anspruch 5, bei dem die Polymerkomponente ein oder mehrere umfasst, die aus der Gruppe ausgewählt sind, die aus einem Acrylharz, einem Silikonharz, einem Epoxidharz, einem Urethanharz, einem Aminoharz und einem Phenolharz besteht.

8. Verbundmaterial nach Anspruch 1, bei dem die Graphenkomponente eine Graphenschicht auf der Oberfläche des Metallschaums oder innerhalb des Metallschaums bildet.

9. Verbundmaterial nach Anspruch 8, bei dem die Graphenschicht eine einschichtige oder mehrschichtige Struktur ist.

10. Verbundmaterial nach Anspruch 8, bei dem die Graphenschicht eine Dicke im Bereich von 10 nm oder weniger aufweist.

11. Verbundmaterial nach Anspruch 1, bei dem das Verbundmaterial eine Wärmeleitfähigkeit von 1,65 W/mK oder mehr aufweist.

12. Verfahren zur Herstellung des Verbundmaterials nach Anspruch 1, umfassend das Bilden der Graphenkomponente auf der Oberfläche oder innerhalb des Metallschaums.

## Revendications

1. Matériau composite comprenant une mousse métallique et un composant graphénique présent sur la surface de la mousse métallique ou à l'intérieur de la mousse métallique,
où la mousse métallique a une gramme d'épaisseurs de 70 µm à 270 µm ; et
où la mousse métallique a des pores et une porosité, telle que calculée sur la base de la densité de la mousse métallique, dans une gamme de 80 % à 98 %.

2. Matériau composite selon la revendication 1, où le composant graphénique est inclus dans le matériau composite à une teneur dans une gamme de 10⁻⁵ à 10⁻¹ % en poids.

3. Matériau composite selon la revendication 1, où la mousse métallique comprend un métal ou un alliage métallique ayant une conductivité thermique égale ou supérieure à 8 W/mK.

4. Matériau composite selon la revendication 1, où la mousse métallique a un squelette qui comprend un ou plusieurs métaux ou alliages métalliques sélectionnés dans le groupe consistant en les suivants : fer, cobalt, nickel, cuivre, molybdène, zinc, manganèse, chrome, indium, étain, argent, platine, or, aluminium, acier inoxydable et magnésium.

5. Matériau composite selon la revendication 1 comprenant en outre un composant polymère présent sur la surface de la mousse métallique ou du graphène.

6. Matériau composite selon la revendication 5, où le composant polymère forme une couche superficielle sur la surface de la mousse métallique ou du graphène.

7. Matériau composite selon la revendication 5, où le composant polymère comprend une ou plusieurs sélectionnées dans le groupe consistant en une résine acrylique, une résine silicone, une résine époxy, une résine uréthane, une résine aminique et une résine phénolique.

8. Matériau composite selon la revendication 1, où le composant graphénique forme une couche graphénique sur la surface de la mousse métallique ou à l'intérieur de la mousse métallique.

9. Matériau composite selon la revendication 8, où la couche graphénique est une structure à couche unique ou à couches multiples.

10. Matériau composite selon la revendication 8, où la couche graphénique a une gamme d'épaisseurs de 10 nm ou moins.

11. Matériau composite selon la revendication 1, où matériau composite a une conductivité thermique égale ou supérieure à 1,65 W/mK.

12. Procédé de production du matériau composite selon la revendication 1, comprenant la formation du composant graphénique sur la surface ou à l'intérieur de la mousse métallique.
